(19) Europäisches Patentamt
European Patent Office
Office européen des brevets

(11) EP 2 006 890 A2

(12) **EUROPEAN PATENT APPLICATION**
published in accordance with Art. 153(4) EPC

(43) Date of publication:
**24.12.2008 Bulletin 2008/52**

(21) Application number: **07739933.5**

(22) Date of filing: **27.03.2007**

(51) Int Cl.:
***H01L 21/304*** *(2006.01)*

(86) International application number:
**PCT/JP2007/056495**

(87) International publication number:
**WO 2007/119537 (25.10.2007 Gazette 2007/43)**

(84) Designated Contracting States:
**DE FR IT**

(30) Priority: **03.04.2006 JP 2006101502**

(71) Applicants:
- **JSR Corporation**
  **Tokyo 104-8410 (JP)**
- **Kabushiki Kaisha Toshiba**
  **Minato-ku,**
  **Tokyo 105-8001 (JP)**

(72) Inventors:
- **UCHIKURA, Kazuhito**
  **Tokyo 104-8410 (JP)**
- **SHIDA, Hirotaka**
  **Tokyo 104-8410 (JP)**
- **HASHIGUCHI, Yuuichi**
  **Tokyo 104-8410 (JP)**
- **MINAMIHABA, Gaku**
  **Tokyo 105-8001 (JP)**
- **FUKUSHIMA, Dai**
  **Tokyo 105-8001 (JP)**
- **TATEYAMA, Yoshikuni**
  **Tokyo 105-8001 (JP)**
- **YANO, Hiroyuki**
  **Tokyo 105-8001 (JP)**

(74) Representative: **TBK-Patent**
**Bavariaring 4-6**
**80336 München (DE)**

# (54) AQUEOUS DISPERSION FOR CHEMICAL MECHANICAL POLISHING, CHEMICAL MECHANICAL POLISHING METHOD, KIT FOR CHEMICAL MECHANICAL POLISHING, AND KIT FOR PREPARING AQUEOUS DISPERSION FOR CHEMICAL MECHANICAL POLISHING

(57) A chemical mechanical polishing aqueous dispersion comprises (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, the mass ratio (WB/WC) of the amount (WB) of the component (B) to the amount (WC) of the component (C) being 0.01 or more and less than 2, and the component (E) being shown by the following general formula (1),

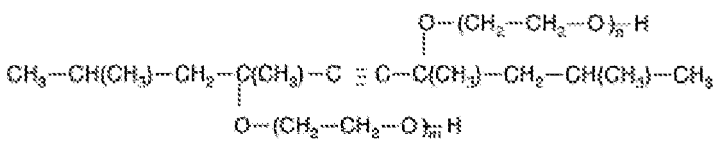

(1)

wherein m and n individually represent integers equal to or larger than one, provided that m+n≤50 is satisfied.

EP 2 006 890 A2

FIG.1A

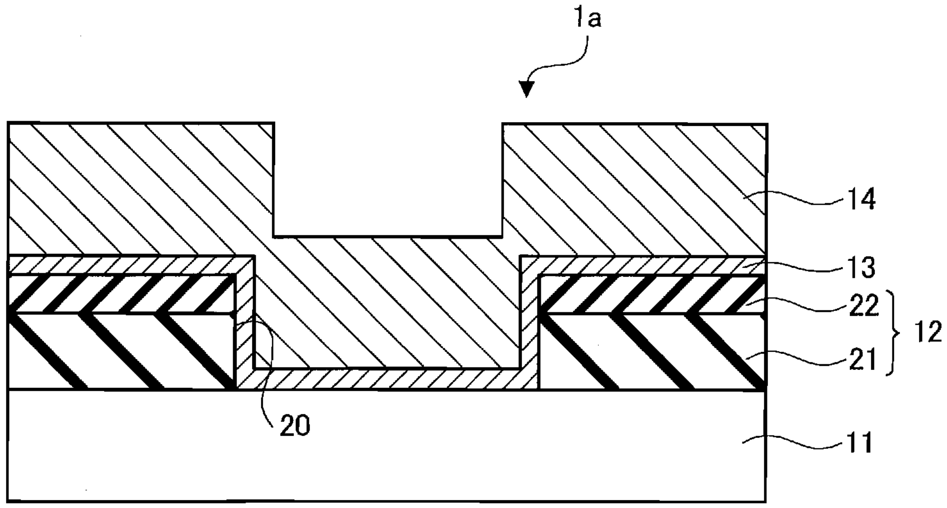

## Description

TECHNICAL FIELD

The present invention relates to a chemical mechanical polishing aqueous dispersion, a chemical mechanical polishing method, a chemical mechanical polishing kit, and a kit for preparing a chemical mechanical polishing aqueous dispersion.

BACKGROUND ART

In recent years, interconnects formed in semiconductor devices have been increasingly scaled down along with an increase in the degree of integration of semiconductor devices. A damascene method has been known as technology capable of scaling down interconnects. In the damascene method, a depression formed in an insulating film is filled with an interconnect material, and unnecessary interconnect material deposited in an area other than the depression is removed by chemical mechanical polishing to form a desired interconnect.

When using copper or a copper alloy as the interconnect material, a barrier metal film is generally formed at the interface between copper or a copper alloy and the insulating material using tantalum, tantalum nitride, titanium nitride, or the like in order to prevent migration of copper atoms into the insulating material.

A low-dielectric-constant interlayer dielectric has been used as an insulating film. In this case, since a low-dielectric-constant interlayer dielectric has low mechanical strength, cracks may occur in the interlayer dielectric during chemical mechanical polishing. In order to prevent cracks which may occur in an insulating film, a laminate of a first insulating film and a second insulating film having a mechanical strength higher than that of the first insulating film may be used as an insulating film, and the second insulating film is mainly removed during chemical mechanical polishing. When subjecting the laminate of the first insulating film and the second insulating film to chemical mechanical polishing, a chemical mechanical polishing aqueous dispersion and a chemical mechanical polishing method for chemically and mechanically polishing the first insulating film and the second insulating film at an optimum polishing rate have been desired (JP-A-2001-196336).

DISCLOSURE OF THE INVENTION

The invention was conceived in view of the above-described situation. An object of the invention is to provide a chemical mechanical polishing aqueous dispersion which enables an insulating film to be polished at an appropriate polishing rate without causing peeling of the insulating film, a chemical mechanical polishing method, a chemical mechanical polishing kit, and a kit for preparing a chemical mechanical polishing aqueous dispersion.

A first aspect of the invention provides a chemical mechanical polishing aqueous dispersion comprising:

(A) abrasive grains;
(B) at least one of quinolinecarboxylic acid and pyridinecarboxylic acid;
(C) an organic acid other than quinolinecarboxylic acid and pyridinecarboxylic acid;
(D) an oxidizing agent; and
(E) a nonionic surfactant having a triple bond,

the mass ratio (WB/WC) of the amount (WB) of the component (B) to the amount (WC) of the component (C) being 0.01 or more and less than 2; and
the component (E) being shown by the following general formula (1),

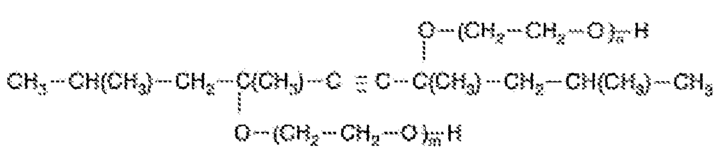

(1)

wherein m and n individually represent integers equal to or larger than one, provided that m+n≤50 is satisfied.

A second aspect of the invention provides a chemical mechanical polishing method that chemically and mechanically polishes a polishing target, the polishing target comprising an insulating film that is provided above a substrate

and has a depression, and a copper film provided on the insulating film through a barrier metal film, the insulating film comprising a first insulating film and a second insulating film that is provided on the first insulating film and has a dielectric constant higher than that of the first insulating film, the method comprising:

a first polishing step of chemically and mechanically polishing the copper film using a first chemical mechanical polishing aqueous dispersion utilizing the barrier metal film as an index; and
a second polishing step of chemically and mechanically polishing the second insulating film using a second chemical mechanical polishing aqueous dispersion utilizing the first insulating film as an index,
the first chemical mechanical polishing aqueous dispersion comprising abrasive grains, an organic acid, an oxidizing agent, and at least one of ammonia and an ammonium ion;
the second chemical mechanical polishing aqueous dispersion comprising (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, the mass ratio (WB/WC) of the amount (WB) of the component (B) to the amount (WC) of the component (C) being 0.01 or more and less than 2, and the component (E) being shown by the following general formula (1),

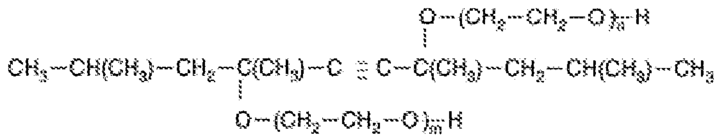

(1)

wherein m and n individually represent integers equal to or larger than one, provided that $m+n \leq 50$ is satisfied;
when chemically and mechanically polishing the copper film and the barrier metal film using the first chemical mechanical polishing aqueous dispersion under identical conditions, a polishing rate ratio ($R_{Cu}/R_{BM}$) of a polishing rate ($R_{Cu}$) of the copper film to a polishing rate ($R_{BM}$) of the barrier metal film being 50 or more; and
when chemically and mechanically polishing the copper film, the barrier metal film, the first insulating film, and the second insulating film using the second chemical mechanical polishing aqueous dispersion under identical conditions, a polishing rate ratio ($R_{BM}/R_{Cu}$) of a polishing rate ($R_{BM}$) of the barrier metal film to a polishing rate ($R_{Cu}$) of the copper film being 1.2 or more, a polishing rate ratio ($R_{In-2}/R_{Cu}$) of a polishing rate ($R_{In-2}$) of the second insulating film to the polishing rate ($R_{Cu}$) of the copper film being 0.5 to 2, and a polishing rate ratio ($R_{In-2}/R_{In-1}$) of the polishing rate ($R_{In-2}$) of the second insulating film to a polishing rate ($R_{In-1}$) of the first insulating film being 0.5 to 10,
**[0008]** A third aspect of the invention provides a chemical mechanical polishing kit comprising a first chemical mechanical polishing aqueous dispersion and a second chemical mechanical polishing aqueous dispersion,
the first chemical mechanical polishing aqueous dispersion and the second chemical mechanical polishing aqueous dispersion being provided in a non-mixed state; the first chemical mechanical polishing aqueous dispersion comprising abrasive grains, an organic acid, an oxidizing agent, and an ammonia component that comprises at least one of ammonia and an ammonium ion; and
the second chemical mechanical polishing aqueous dispersion comprising (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, the mass ratio (WB/WC) of the amount (WB) of the component (B) to the amount (WC) of the component (C) being 0.01 or more and less than 2, and the component (E) being shown by the following general formula (1),

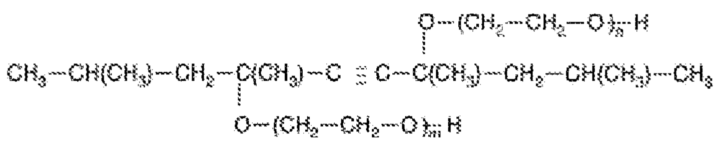

(1)

wherein m and n individually represent integers equal to or larger than one, provided that $m+n \leq 50$ is satisfied.

A fourth aspect of the invention provides a kit for preparing the chemical mechanical polishing aqueous dispersion according to the first aspect or the above second chemical mechanical polishing aqueous dispersion by mixing a liquid (I) and a liquid (II),
the liquid (I) being an aqueous dispersion comprising the component (A), the component (B), the component (C), and the component (E); and
the liquid (II) comprising the component (D).

A fifth aspect of the invention provides a kit for preparing the chemical mechanical polishing aqueous dispersion according to the first aspect or the above second chemical mechanical polishing aqueous dispersion by mixing a liquid (I) and a liquid (II),
the liquid (I) being an aqueous dispersion comprising the component (A); and
the liquid (II) comprising the component (B) and the component (C).

A sixth aspect of the invention provides a kit for preparing the chemical mechanical polishing aqueous dispersion according to the first aspect or the above second chemical mechanical polishing aqueous dispersion by mixing a liquid (I), a liquid (II), and a liquid (II),
the liquid (I) being an aqueous dispersion comprising the component (A);
the liquid (II) comprising the component (B) and the component (C); and
the liquid (III) comprising the component (D).

In the kit according to the fifth aspect or the sixth aspect, the liquid (I) may further comprise one or more components selected from the component (B), the component (C), the component (D), and the component (E).

In the kit according to the fifth aspect or the sixth aspect, the liquid (II) may further comprise one or more components selected from the component (A), the component (D), and the component (E).

The expression "chemically and mechanically polishing the copper film utilizing the barrier metal film as an index" used herein comprises the case where chemical mechanical polishing is continuously performed after the surface of the barrier metal film has been exposed and finished when the barrier metal film has been polished to an appropriate extent, and the case where chemical mechanical polishing is finished immediately before the surface of the barrier metal film is exposed. The expression "chemically and mechanically polishing the second insulating film utilizing the first insulating film as an index" used herein comprises the case where the barrier metal film is completely removed, the case where the second insulating film remains, and the case where chemical mechanical polishing is finished when the first insulating film has been polished to an appropriate extent.

Since the above chemical mechanical polishing aqueous dispersion comprises the components (A) to (E) and the mass ratio (WB/WC) of the amount (WB) of the component (B) to the amount (WC) of the component (C) is 0.01 or more and less than 2, an insulating film can be polished at an appropriate polishing rate without causing peeling of the insulating film.

According to the chemical mechanical polishing method using the above chemical mechanical polishing aqueous dispersion, the chemical mechanical polishing kit comprising the above chemical mechanical polishing aqueous dispersion, and the kit for preparing the above chemical mechanical polishing aqueous dispersion, each polishing target can be efficiently polished by chemical mechanical polishing using the above chemical mechanical polishing aqueous dispersion to obtain a sufficiently planarized and accurately finished surface.

BRIEF DESCRIPTION OF THE DRAWINGS

FIG. 1A is a schematic view showing a specific example of a chemical mechanical polishing method according to the invention.

FIG. 1B is a schematic view showing a specific example of a chemical mechanical polishing method according to the invention.

FIG. 1C is a schematic view showing a specific example of a chemical mechanical polishing method according to the invention.

FIG. 1D is a schematic view showing a specific example of a chemical mechanical polishing method according to the invention.

FIG. 2A is a schematic view showing a specific example of a chemical mechanical polishing method according to the invention.

FIG. 2B is a schematic view showing a specific example of a chemical mechanical polishing method according to the invention.

FIG. 2C is a schematic view showing a specific example of a chemical mechanical polishing method according to the invention.

FIG. 2D is a schematic view showing a specific example of a chemical mechanical polishing method according to the invention.

BEST MODE FOR CARRYING OUT THE INVENTION

Embodiments of the invention are described below with reference to the drawings. Note that the invention is not limited to the following embodiments. The invention comprises various modifications within the spirit and scope of the invention.

1. Chemical mechanical polishing aqueous dispersion

A chemical mechanical polishing aqueous dispersion according to one embodiment of the invention comprises (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, wherein the mass ratio (WB/WC) of the amount (WB) of the component (B) to the amount (WC) of the component (C) is 0.01 or more and less than 2, and the component (E) is shown by the following general formula (1).

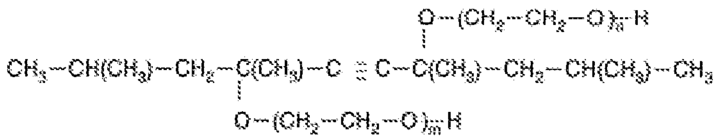

(1)

wherein m and n individually represent integers equal to or larger than one, provided that $m+n \leq 50$ is satisfied.

The chemical mechanical polishing aqueous dispersion according to this embodiment is characterized in that, when chemically and mechanically polishing a copper film, a barrier metal film, a first insulating film, and a second insulating film having a dielectric constant higher than that of the first insulating film using the chemical mechanical polishing aqueous dispersion under identical conditions, a polishing rate ratio ($R_{BM}/R_{Cu}$) of a polishing rate ($R_{BM}$) of the barrier metal film to a polishing rate ($R_{Cu}$) of the copper film is 1.2 or more, a polishing rate ratio ($R_{In-2}/R_{Cu}$) of a polishing rate ($R_{In-2}$) of the second insulating film to the polishing rate ($R_{Cu}$) of the copper film is 0.5 to 2, and a polishing rate ratio ($R_{In-2}/R_{In-1}$) of a polishing rate ($R_{In-2}$) of the second insulating film to a polishing rate ($R_{In-1}$) of the first insulating film is 0.5 to 10.

Each component of the chemical mechanical polishing aqueous dispersion according to one embodiment of the invention is described below.

1.1. Component (A)

The abrasive grains used as the component (A) (hereinafter may be referred to as "abrasive grains (A)") may be at least one type of abrasive grains selected from inorganic particles, organic particles, and organic-inorganic composite particles.

Examples of the inorganic particles include silica, alumina, titania, zirconia, ceria, and the like. Examples of the silica include fumed silica, silica synthesized by a sol-gel method, colloidal silica, and the like. The fumed silica may be obtained by reacting silicon chloride or the like with oxygen and water in a gaseous phase. The silica synthesized by the sol-gel method may be obtained by hydrolysis and/or condensation of an alkoxysilicon compound as a raw material. The colloidal silica may be obtained by an inorganic colloid method using a raw material purified in advance, for example.

Examples of the organic particles include polyvinyl chloride, a styrene (co)polymer, polyacetal, polyester, polyamide, polycarbonate, an olefin (co)polymer, a phenoxy resin, an acrylic (co)polymer, and the like. Examples of the olefin (co)polymer include polyethylene, polypropylene, poly-1-butene, poly-4-methyl-1-pentene, and the like. Examples of the acrylic (co)polymer include polymethyl methacrylate and the like.

The type and the configuration of the organic-inorganic composite particles are not particularly limited insofar as inorganic particles and organic particles as mentioned above are integrally formed in such a manner that the inorganic particles and the organic particles are not easily separated during a chemical mechanical polishing step. The organic-inorganic composite particles may have one of the following configurations (i) to (iii), for example.

(i) Organic-inorganic composite particles obtained by polycondensation of an alkoxide compound of a metal or silicon in the presence of organic particles. Examples of the alkoxide compound of a metal or silicon include an alkoxysilane, an aluminum alkoxide, a titanium alkoxide, and the like. The resulting polycondensate may be bonded to a functional group of the organic particle either directly or through an appropriate coupling agent (e.g., silane coupling agent).

(ii) Organic-inorganic composite particles in which organic particles and inorganic particles having zeta potentials of opposite polarities (positive or negative) are bonded due to an electrostatic force. In this case, the composite particles may be formed by mixing the organic particles and the inorganic particles in a pH region in which the organic particles and the inorganic particles have zeta potentials of opposite polarities, or may be formed by mixing the organic particles and the inorganic particles in a pH region in which the organic particles and the inorganic particles have zeta potentials of an identical polarity and then changing the liquid property to a pH region in which the organic particles and the inorganic particles have zeta potentials of opposite polarities.

(iii) Organic-inorganic composite particles obtained by polycondensation of an alkoxide compound of a metal or silicon in the presence of the composite particles (ii). As the alkoxide compound of a metal or silicon, the alkoxide compound mentioned for the organic-inorganic composite particles (i) may be used.

The abrasive grains (A) are preferably at least one type of abrasive grains selected from silica, the organic particles, and the organic-inorganic composite particles mentioned above, with silica being particularly preferable.

The average particle diameter of the abrasive grains (A) is preferably 5 to 500 nm, more preferably 20 to 200 nm, and still more preferably 40 to 150 nm. An appropriate polishing rate can be achieved using the abrasive grains (A) having an average particle diameter within this range.

The abrasive grains (A) are preferably used in an amount of 1 to 10 mass%, more preferably 2 to 8 mass%, and still more preferably 3 to 6 mass% based on the total amount of the chemical mechanical polishing aqueous dispersion according to this embodiment. If the amount of the abrasive grains (A) is more than 10 mass%, an increase in cost occurs although the polishing rate can be increased. If the amount of the abrasive grains (A) is less than 1 mass%, the throughput of semiconductor production decreases due to a decrease in polishing rate.

1.2. Component (B)

The component (B) is at least one of quinolinecarboxylic acid and pyridinecarboxylic acid. Examples of the quinolinecarboxylic acid include unsubstituted quinolinecarboxylic acid and substituted quinolinecarboxylic acid in which one or more hydrogen atoms are replaced by a hydroxyl group, a halogen atom, or the like in a site other than the carboxyl group.

Examples of the pyridinecarboxylic acid include unsubstituted pyridinecarboxylic acid and substituted pyridinecarboxylic acid in which one or more hydrogen atoms are replaced by a hydroxyl group, a halogen atom, or the like in a site other than the carboxyl group.

Among these, unsubstituted quinolinecarboxylic acid and unsubstituted pyridinecarboxylic acid are preferable, with 2-quinolinecarboxylic acid (quinaldic acid) and 2,3-pyridinedicarboxylic acid (quinolinic acid) being particularly preferable. The quinolinecarboxylic acid and the pyridinecarboxylic acid may be carboxylates obtained by incorporating a salt (e.g., potassium salt or ammonium salt).

The component (B) is preferably used in an amount of 0.01 to 10 mass%, more preferably 0.03 to 5 mass%, and still more preferably 0.05 to 3 mass% based on the total amount of the chemical mechanical polishing aqueous dispersion according to this embodiment. If the amount of the component (B) is less than 0.01 mass%, a copper film may not be polished at a sufficient polishing rate. If the amount of the component (B) is more than 10 mass%, other components may not be incorporated in desired amounts.

1.3. Component (C)

The component (C) is an organic acid other than quinolinecarboxylic acid and pyridinecarboxylic acid.

As the component (C), various organic acids such as a monobasic acid (e.g., monocarboxylic acid), a dibasic acid (e.g., dicarboxylic acid), a hydroxyl acid, and a carboxylate acid may be used. Examples of such organic acids include a saturated acid, an unsaturated acid, an aromatic acid, and the like.

Examples of the saturated acid include formic acid, acetic acid, butyric acid, oxalic acid, malonic acid, succinic acid, glutaric acid, adipic acid, a hydroxyl acid, and the like. Examples of the hydroxyl acid include lactic acid, malic acid, tartaric acid, citric acid, and the like.

Examples of the unsaturated acid include maleic acid, fumaric acid, and the like.

Examples of the aromatic acid include benzoic acid, phthalic acid, and the like.

It is preferable to use an organic acid having four or more carbon atoms in order to obtain a flat polished surface

with high accuracy. It is more preferable to use a carboxylic acid having four or more carbon atoms. It is further preferable to use an aliphatic carboxylic acid having four or more carbon atoms, with an aliphatic carboxylic acid having a molecular weight of 105 or more and having four or more carbon atoms being particularly preferable. As the aliphatic carboxylic acid having a molecular weight of 105 or more and having four or more carbon atoms, a carboxylic acid having two or more carboxyl groups in one molecule is preferable, with a dicarboxylic acid (most preferably an unsaturated dicarboxylic acid) being particularly preferable.

The component (C) may be a carboxylate obtained by incorporating a salt (e.g., potassium salt or ammonium salt).

The component (C) is preferably used in an amount of 0.01 to 10 mass%, more preferably 0.05 to 5 mass%, and still more preferably 0.1 to 3 mass% based on the total amount of the chemical mechanical polishing aqueous dispersion according to this embodiment. If the amount of the component (C) is less than 0.01 mass%, a barrier metal film may not be polished at a sufficient polishing rate. If the amount of the component (C) is more than 10 mass%, the polishing target surface may be corroded.

In the chemical mechanical polishing aqueous dispersion according to this embodiment, the mass ratio (WB/WC) of the amount (WB) of the component (B) to the amount (WC) of the component (C) is 0.01 or more and less than 2, preferably 0.01 to 1.5, more preferably 0.02 to 1.0, still more preferably 0.03 to 0.75, and particularly preferably more than 0.05 and 0.5 or less.

If the mass ratio (WB/WC) is two or more, when chemically and mechanically polishing a copper film, a barrier metal film, a first insulating film, and a second insulating film having a dielectric constant higher than that of the first insulating film using the chemical mechanical polishing aqueous dispersion according to this embodiment under identical conditions, the polishing rate ratio ($R_{BM}/R_{Cu}$) of the polishing rate ($R_{BM}$) of the barrier metal film to the polishing rate ($R_{Cu}$) of the copper film may be less than 1.2 or more.

If the mass ratio (WB/WC) is less than 0.01, when chemically and mechanically polishing a copper film, a barrier metal film, a first insulating film, and a second insulating film having a dielectric constant higher than that of the first insulating film using the chemical mechanical polishing aqueous dispersion according to this embodiment under identical conditions, the polishing rate ratio ($R_{In-2}/R_{Cu}$) of the polishing rate ($R_{In-2}$) of the second insulating film to the polishing rate ($R_{Cu}$) of the copper film may be outside the range of 0.5 to 2. As a result, a polished surface having excellent surface characteristics (e.g., flatness) may not be obtained.

## 1.4. Oxidizing agent (D)

Examples of the oxidizing agent used as the component (D) include a persulfate, hydrogen peroxide, an inorganic acid, an organic peroxide, a polyvalent metal salt, and the like. Examples of the persulfate include ammonium persulfate, potassium persulfate, and the like. Examples of the inorganic acid include nitric acid, sulfuric acid, and the like. Examples of the organic peroxide include peracetic acid, perbenzoic acid, tert-butyl hydroperoxide, and the like.

Examples of the polyvalent metal salt include a permanganic acid compound, a dichromic acid compound, and the like. Examples of the permanganic acid compound include potassium permanganate and the like. Examples of the dichromic acid compound include potassium dichromate and the like. Among these, hydrogen peroxide, the persulfate, and the inorganic acid are preferable, with hydrogen peroxide being particularly preferable from the viewpoint of purity and handling capability.

The oxidizing agent (D) is preferably used in an amount of 0.001 to 2 mass%, more preferably 0.01 to 2 mass%, and still more preferably 0.05 to 1.5 mass% based on the total amount of the chemical mechanical polishing aqueous dispersion according to this embodiment. An appropriate polishing rate can be achieved by incorporating the oxidizing agent (D) in an amount within this range.

When using hydrogen peroxide as the component (D) in the chemical mechanical polishing aqueous dispersion according to one embodiment of the invention, an appropriate polyvalent metal ion (e.g., iron sulfate hydrate) which promotes the function of hydrogen peroxide as the oxidizing agent and increases the polishing rate may be added to the chemical mechanical polishing aqueous dispersion.

## 1.5. Component (E)

Examples of the component (E) (i.e., the nonionic surfactant having a triple bond shown by the general formula (1)) include an ethylene oxide adduct of acetylene glycol and the like. The hydrophilic-lipophilic balance of the nonionic surfactant having a triple bond in terms of an HLB value is preferably 3 to 20, and particularly preferably 5 to 20.

Examples of commercially available products of the component (E) include Surfynol 440 (HLB value=8), Surfynol 465 (2,4,7,9-tetramethyl-5-decyne-4,7-diol-dipolyoxyethylene ether, HLB value=13), and Surfynol 485 (2,4,7,9-tetramethyl-5-decyne-4,7-diol-dipolyoxyethylene ether, HLB value=17) (manufactured by Air Products Japan, Inc.).

Chemical mechanical polishing can be carried out at an appropriate polishing rate using the nonionic surfactant

shown by the general formula (1). In the general formula (1), it is preferable that n+m be 10≤n+m≤50, and more preferably 20≤n+m≤40.

The component (E) is preferably used in an amount of 0.001 to 1 mass%, and more preferably 0.005 to 0.5 mass, based on the total amount of the chemical mechanical polishing aqueous dispersion according to this embodiment. An appropriate polishing rate can be achieved by incorporating the component (E) in an amount within this range.

The chemical mechanical polishing aqueous dispersion according to this embodiment may include a nonionic surfactant having a triple bond (e.g., acetylene glycol and acetylene alcohol) other than the component (E). Examples of the acetylene glycol include Surfynol 82 (HLB value=5 to 7) and Surfynol 104 (HLB value=3 to 5) (manufactured by Air Products Japan, Inc.). Examples of the acetylene alcohol include Surfynol 61 (HLB value=4 to 6) (manufactured by Air Products Japan, Inc.).

1.6. Component (F)

It is preferable that the chemical mechanical polishing aqueous dispersion according to this embodiment include (F) water as an aqueous medium. The chemical mechanical polishing aqueous dispersion according to this embodiment may include an alcohol or an organic solvent miscible with water in addition to the water (F).

1.7. pH of chemical mechanical polishing aqueous dispersion

The pH of the chemical mechanical polishing aqueous dispersion according to this embodiment is preferably 8 to 13, and more preferably 9 to 12. An appropriate polishing rate can be achieved by adjusting the pH of the chemical mechanical polishing aqueous dispersion to this range. Examples of a PH adjusting agent include an organic base, an inorganic base, and an inorganic acid. Examples of the organic base include tetramethylammonium hydroxide, triethylamine, and the like. Examples of the inorganic base include ammonia, potassium hydroxide, sodium hydroxide, and the like. Examples of the inorganic acid include nitric acid, sulfuric acid, and the like.

1.8. Kit for preparing chemical mechanical polishing aqueous dispersion

The chemical mechanical polishing aqueous dispersion according to this embodiment may be supplied in a state in which the chemical mechanical polishing aqueous dispersion can be directly used as a polishing composition after the preparation. Alternatively, a polishing composition containing each component of the chemical mechanical polishing aqueous dispersion according to this embodiment at a high concentration (i.e., concentrated polishing composition) may be provided, and the concentrated polishing composition may be diluted before use to obtain a desired chemical mechanical polishing aqueous dispersion.

For example, the chemical mechanical polishing aqueous dispersion according to this embodiment may be separately provided as a plurality of liquids (e.g., two or three liquids), and the liquids may be mixed before use. For example, the chemical mechanical polishing aqueous dispersion according to this embodiment may be prepared by mixing a plurality of liquids using first to third kits given below.

1.8.1. First kit

The first kit is a kit for preparing the chemical mechanical polishing aqueous dispersion according to this embodiment by mixing a liquid (I) and a liquid (II). In the first kit, the liquid (I) is an aqueous dispersion including the component (A), the component (B), the component (C), and the component (E), and the liquid (II) includes the component (D).

When preparing the liquid (I) and the liquid (II) of the first kit, it is necessary to determine the concentration of each component in the liquid (I) and the liquid (II) so that each component is included in an aqueous dispersion obtained by mixing the liquid (I) and the liquid (II) in the above-mentioned concentration range. Each of the liquid (I) and the liquid (II) may contain each component at a high concentration (i.e. may be concentrated). In this case, the liquid (I) and the liquid (II) may be diluted before use. According to the first kit, the storage stability of the oxidizing agent can be improved by separately providing the liquid (I) and the liquid (II).

When preparing the chemical mechanical polishing aqueous dispersion according to this embodiment using the first kit, it suffices that the liquid (I) and the liquid (II) be separately provided (supplied) and be integrally mixed at the time of polishing. The mixing method and the mixing timing are not particularly limited.

For example, the liquid (I) and the liquid (II) may be separately supplied to a polishing system and be mixed on a platen. Alternatively, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.2. Second kit

The second kit is a kit for preparing the chemical mechanical polishing aqueous dispersion according to this embodiment by mixing a liquid (I) and a liquid (II). In the second kit, the liquid (I) is an aqueous dispersion including the component (A), and the liquid (II) includes the component (B) and the component (C).

When preparing the liquid (I) and the liquid (II) of the second kit, it is necessary to determine the concentration of each component in the liquid (I) and the liquid (II) so that each component is included in an aqueous dispersion obtained by mixing the liquid (I) and the liquid (II) in the above-mentioned concentration range. Each of the liquid (I) and the liquid (II) may contain each component at a high concentration (i.e. may be concentrated). In this case, the liquid (I) and the liquid (II) may be diluted before use. According to the second kit, the storage stability of the aqueous dispersion can be improved by separately providing the liquid (I) and the liquid (II).

When preparing the chemical mechanical polishing aqueous dispersion according to this embodiment using the second kit, it suffices that the liquid (I) and the liquid (II) be separately provided (supplied) and integrally mixed at the time of polishing. The mixing method and the mixing timing are not particularly limited.

For example, the liquid (I) and the liquid (II) may be separately supplied to a polishing system and be mixed on a platen. Alternatively, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.3. Third kit

The third kit is a kit for preparing the chemical mechanical polishing aqueous dispersion according to this embodiment by mixing a liquid (I), a liquid (II), and a liquid (III). In the third kit, the liquid (I) is an aqueous dispersion including the component (A), the liquid (II) includes the component (B) and the component (C), and the liquid (III) includes the component (D).

When preparing the liquid (I), the liquid (II), and the liquid (III) of the third kit, it is necessary to determine the concentration of each component in the liquid (I), the liquid (II), and the liquid (III) so that each component is included in an aqueous dispersion obtained by mixing the liquid (I), the liquid (II), and the liquid (III) in the above-mentioned concentration range. Each of the liquid (I), the liquid (II), and the liquid (III) may contain each component at a high concentration (i.e. may be concentrated). In this case, the liquid (I), the liquid (II), and the liquid (III) may be diluted before use. According to the third kit, the storage stability of the aqueous dispersion can be improved by separately providing the liquid (I), the liquid (II), and the liquid (III).

When preparing the chemical mechanical polishing aqueous dispersion according to this embodiment using the third kit, it suffices that the liquid (I), the liquid (II), and the liquid (III) be separately provided (supplied) and be integrally mixed at the time of polishing. The mixing method and the mixing timing are not particularly limited.

For example, the liquid (I), the liquid (II), and the liquid (III) may be separately supplied to a polishing system and mixed on a platen. Or, the liquid (I), the liquid (II), and the liquid (III) may be mixed before being supplied to the polishing system, or may be mixed in the polishing system when supplied through a line, or may be mixed in a mixing tank additionally provided. A line mixer or the like may be used to obtain a more uniform aqueous dispersion.

In the second kit or the third kit, the liquid (I) may further include one or more components selected from the component (B), the component (C), the component (D), and the component (E), and the liquid (II) may further include one or more components selected from the component (A), the component (D), and the component (E).

1.9. Application

The chemical mechanical polishing aqueous dispersion according to this embodiment may be suitably used for chemical mechanical polishing of a polishing target (e.g., semiconductor device). Specifically, since the chemical mechanical polishing aqueous dispersion according to this embodiment is prepared so that the mass ratio (WB/WC) of the amount (WB) of the component (B) to the amount (WC) of the component (C) is 0.01 or more and less than 2, an insulating film can be polished at an appropriate polishing rate without causing peeling of the insulating film.

More specifically, the chemical mechanical polishing aqueous dispersion according to this embodiment may be suitably used as a second chemical mechanical polishing aqueous dispersion in a second polishing step of a two-stage polishing process for forming a copper damascene interconnect described later, for example.

2. Chemical mechanical polishing method

A chemical mechanical polishing method according to one embodiment of the invention is a method for chemically and mechanically polishing a polishing target which includes an insulating film that is provided on a substrate and

has a depression, and a copper film provided on the insulating film through a barrier metal film. The insulating film includes a first insulating film and a second insulating film which is provided on the first insulating film and has a dielectric constant higher than that of the first insulating film.

The chemical mechanical polishing method includes a first polishing step and a second polishing step.

In the first polishing step, the copper film is chemically and mechanically polished using a first chemical mechanical polishing aqueous dispersion utilizing the barrier metal film as an index. Note that chemical mechanical polishing may be continuously performed after the surface of the barrier metal film has been exposed, and finished when the barrier metal film has been polished to an appropriate extent. Alternatively, chemical mechanical polishing may be finished immediately before the surface of the barrier metal film is exposed so that the copper film partially remains.

In the second polishing step, the second insulating film is chemically and mechanically polished using a second chemical mechanical polishing aqueous dispersion utilizing the first insulating film as an index. Note that chemical mechanical polishing may be continuously performed after the surface of the first insulating film has been exposed, and finished when the first insulating film has been polished to an appropriate extent. Alternatively, chemical mechanical polishing may be finished immediately before the surface of the first insulating film is exposed so that the second insulating film partially remains.

The first chemical mechanical polishing aqueous dispersion includes abrasive grains, an organic acid, an oxidizing agent, and at least one of ammonia and an ammonium ion. In the first chemical mechanical polishing aqueous dispersion, the oxidizing agent is preferably ammonium persulfate.

When chemically and mechanically polishing the copper film and the barrier metal film using the first chemical mechanical polishing aqueous dispersion under identical conditions, the polishing rate ratio ($R_{Cu}/R_{BM}$) of the polishing rate ($R_{Cu}$) of the copper film to the polishing rate ($R_{BM}$) of the barrier metal film is 50 or more.

As the first chemical mechanical polishing aqueous dispersion, a mixture obtained by mixing CMS7401, CMS7452 (manufactured by JSR Corporation), ion-exchanged water, and a 4 wt% ammonium persulfate aqueous solution in a weight ratio of 1:1:2:4 may be suitably used.

As the second chemical mechanical polishing aqueous dispersion, the chemical mechanical polishing aqueous dispersion according to the above embodiment may be used.

When using the chemical mechanical polishing aqueous dispersion according to the above embodiment as a chemical mechanical polishing aqueous dispersion in a second polishing step of a two-stage polishing process for forming a copper damascene interconnect, the polishing rates necessary for the copper film, the barrier metal film, and the insulating film (particularly a silicon oxide film material) can be obtained, and a polished surface having excellent flatness can be efficiently obtained.

A specific example of the chemical mechanical polishing method according to this embodiment is described below with reference to FIGS. 1A to 1D and FIGS. 2A to 2D.

As an example of a polishing target subjected to the chemical mechanical polishing method according to this embodiment, a composite substrate material 1a having a structure shown in FIG. 1A can be given. The composite substrate material 1a includes a substrate 11 formed of silicon or the like, an insulating film 12, a wiring depression 20 formed in the insulating film 12, a barrier metal film 13 formed to cover the insulating film 12 and the bottom and the inner wall of the depression 20, and a copper film 14 formed over the depression 20 through the barrier metal film 13.

The insulating layer 12 has a layered structure formed of two or more layers. As shown in FIG. 1A, the insulating film 12 may be a laminate of a first insulating film 21 and a second insulating film 22 having a dielectric constant higher than that of the first insulating film 21, for example. The first insulating film 21 is a film formed using "Black Diamond" (manufactured by Applied Materials), for example. The second insulating film 22 is formed of PETEOS, for example. The second insulating film 22 may be formed by CVD using tetraethoxysilane.

The barrier metal film 13 is formed of a high-melting-point metal or a high-melting-point metal compound such as tantalum, titanium, tantalum nitride, or titanium nitride. The copper film 14 is formed of a copper-containing metal material such as copper or a copper alloy.

In the polishing target subjected to the chemical mechanical polishing method according to this embodiment, another insulating film may be provided between the substrate 11 and the insulating film 12. For example, a composite substrate material 2a shown in FIG. 2A includes a third insulating film 31 formed of silicon oxide or the like, and a fourth insulating film 32 provided on the third insulating film 31 and formed of silicon nitride or the like, the third insulating film 31 and the fourth insulating film 32 being provided between the substrate 11 and the insulating film 12.

In the chemical mechanical polishing method according to this embodiment, the composite substrate material 1a or 2a may be polished according to the following process, for example. In the first polishing step, the copper film 14 is chemically and mechanically polished using the first chemical mechanical polishing aqueous dispersion utilizing the barrier metal film 13 as an index (see FIGS. 1B and 2B). Note that chemical mechanical polishing may be continuously performed after the surface of the barrier metal film 13 has been exposed, and finished when the barrier metal film 13 has been polished to an appropriate extent. Alternatively, chemical mechanical polishing may be finished immediately before the surface of the barrier metal film 13 is exposed so that the copper film 14 partially remains. In the second

polishing step, chemical mechanical polishing is performed using the second chemical mechanical polishing aqueous dispersion utilizing the first insulating film 21 as an index so that the barrier metal film 13 is removed in the area other than the bottom and the inner wall of the depression 20, and the second insulating film 22 is also removed. Note that chemical mechanical polishing may be continuously performed after the surface of the first insulating film 21 has been exposed, and finished when the first insulating film 21 has been polished to an appropriate extent. Alternatively, chemical mechanical polishing may be finished immediately before the surface of the first insulating film 21 is exposed so that the second insulating film 22 partially remains. A highly planarized damascene wiring structure 1 or 2 is obtained by the above steps (see FIGS. 1C, 1D, 2C, and 2D).

The polishing process using the chemical mechanical polishing method according to this embodiment may be performed under known polishing conditions using a commercially available chemical mechanical polishing system (e.g., "LGP510" or "LGP552" manufactured by Lapmaster SFT Corporation, "EPO-112" or "EPO-222" manufactured by Ebara Corporation, "Mirra" manufactured by Applied Materials, Inc., or "AVANTI-472" manufactured by IPEC).

Preferable polishing conditions are appropriately set depending on the chemical mechanical polishing system used. For example, when using "EPO-112" as the chemical mechanical polishing system, the first polishing step and the second polishing step may be carried out under the following conditions.

Platen rotational speed: preferably 30 to 120 rpm, and more preferably 40 to 100 rpm Head rotational speed: preferably 30 to 120 rpm, and more preferably 40 to 100 rpm Ratio of platen rotational speed/head rotational speed: preferably 0.5 to 2, and more preferably 0.7 to 1.5

Polishing pressure: preferably 60 to 200 g/cm$^2$, and more preferably 100 to 150 g/cm$^2$ Chemical mechanical polishing aqueous dispersion supply rate: preferably 50 to 300 ml/min, and more preferably 100 to 200 ml/min

## 3. Chemical mechanical polishing kit

A chemical mechanical polishing kit according to one embodiment of the invention includes the first chemical mechanical polishing aqueous dispersion and the second chemical mechanical polishing aqueous dispersion described above.

In the chemical mechanical polishing kit according to this embodiment, the first chemical mechanical polishing aqueous dispersion and the second chemical mechanical polishing aqueous dispersion are provided in a non-mixed state. The first chemical mechanical polishing aqueous dispersion and the second chemical mechanical polishing aqueous dispersion are used in different polishing steps. Specifically, the first chemical mechanical polishing aqueous dispersion is used for chemical mechanical polishing of the copper film in the first polishing step, and the second chemical mechanical polishing aqueous dispersion is used for chemical mechanical polishing of the second insulating film in the second polishing step.

The configurations and the properties of the first chemical mechanical polishing aqueous dispersion and the second chemical mechanical polishing aqueous dispersion are the same as described above.

## 4. Examples

The invention is described below by way of examples. Note that the invention is not limited to the following examples.

### 4.1. Preparation of aqueous dispersion containing inorganic particles

#### 4.1.1. Preparation Example 1 (preparation of aqueous dispersion containing fumed silica 1)

2 kg of fumed silica particles ("Aerosil #90" manufactured by Nippon Aerosil Co., Ltd., average primary particle diameter: 20 nm) were dispersed in 6.7 kg of ion-exchanged water using an ultrasonic mixer. The mixture was filtered through a filter having a pore diameter of 5 micrometers to obtain an aqueous dispersion containing the fumed silica particles (hereinafter referred to as "fumed silica 1"). The average secondary particle diameter of the fumed silica 2 was 220 nm.

#### 4.1.2. Preparation Example 2 (preparation of aqueous dispersion containing fumed silica 2)

An aqueous dispersion containing fumed silica particles (hereinafter referred to as "fumed silica 2") was obtained in the same manner as in Preparation Example 1, except for using 2 kg of fumed silica particles ("Aerosil #200" manufactured by Nippon Aerosil Co., Ltd., average primary particle diameter: 7 nm) instead of "Aerosil #90". The average secondary particle diameter of the fumed silica 2 was 140 nm.

4.1.3. Preparation of aqueous dispersion containing colloidal silica particles

4.1.3-1. Preparation of aqueous dispersion containing colloidal silica 1

A flask was charged with 70 parts by mass of 25 mass% aqueous ammonia, 40 parts by mass of ion-exchanged water, 170 parts by mass of ethanol, and 20 parts by mass of tetraethoxysilane. The mixture was heated to 60°C with stirring at a rotational speed of 180 rpm. After stirring the mixture at 60°C for two hours, the mixture was cooled to room temperature. An alcohol dispersion of colloidal silica particles was thus obtained.

The alcohol was removed from the dispersion at 80°C using a rotary evaporator while adding ion-exchanged water. This operation was repeated several times. An aqueous dispersion containing 20 mass% of colloidal silica particles (hereinafter referred to as "colloidal silica 1") was thus prepared. The average primary particle diameter, the average secondary particle diameter, and the average degree of association of the colloidal silica 1 were 25 nm, 40 nm, and 1.6, respectively.

4.1.3-2. Preparation of aqueous dispersion containing colloidal silica 2, 3, or 4

An aqueous dispersion containing colloidal silica 2, 3, or 4 was prepared in the same manner as in "4.1.3-1. Preparation of aqueous dispersion containing colloidal silica 1", except for changing the amounts of 25 mass% aqueous ammonia, ethanol, and tetraethoxysilane as shown in Table 1.

TABLE 1

| Colloidal silica | Amount of raw material | | | Colloidal silica content in aqueous dispersion (mass%) | Average primary particle diameter (nm) | Average secondary particle diameter (nm) |
|---|---|---|---|---|---|---|
| | Aqueous ammonia (concentration: 25 mass%) (parts by mass) | Ethanol (parts by mass) | Tetraethoxysilane (parts by mass) | | | |
| Colloidal silica 1 | 70 | 170 | 20 | 20.0 | 25 | 40 |
| Colloidal silica 2 | 65 | 175 | 25 | 20.0 | 35 | 55 |
| Colloidal silica 3 | 55 | 190 | 35 | 20.0 | 50 | 75 |
| Colloidal silica | 50 | 195 | 35 | 20.0 | 60 | 90 |

4.2. Preparation of aqueous dispersion containing organic-inorganic composite particles

4.2.1. Preparation of aqueous dispersion containing surface-treated organic particles

A flask was charged with 90 parts by mass of methyl methacrylate, 5 parts by mass of methoxy polyethylene glycol methacrylate ("NK Ester M-90G #400" manufactured by Shin-Nakamura Chemical Co., Ltd.), 5 parts by mass of 4-vinylpyridine, 2 parts by mass of an azo initiator ("V50" manufactured by Wako Pure Chemical Industries, Ltd.), and 400 parts by mass of ion-exchanged water. The mixture was heated to 70°C with stirring in a nitrogen gas atmosphere. The mixture was then stirred at 70°C for six hours. The reaction mixture was diluted with ion-exchanged water to obtain an aqueous dispersion containing 10 mass% of polymethyl methacrylate particles having a functional group containing a cation of an amino group and a polyethylene glycol chain, and having an average particle diameter of 150 nm. The polymerization yield was 95%.

A flask was charged with 100 parts by mass of the resulting aqueous dispersion. After the addition of 1 part by mass of methyltrimethoxysilane, the mixture was stirred at 40°C for two hours. The pH of the mixture was adjusted to 2.0 by adding a 1N nitric acid aqueous solution to obtain an aqueous dispersion containing surface-treated organic particles. The zeta potential of the surface-treated organic particles contained in the aqueous dispersion was +17 mV.

4.2.2. Preparation of aqueous dispersion containing inorganic particles (colloidal silica particles)

Colloidal silica particles ("Snowtex O" manufactured by Nissan Chemical Industries, Ltd., average primary particle diameter: 12 nm) were dispersed in water. The pH of the mixture was adjusted using a 1N potassium hydroxide aqueous solution to obtain an aqueous dispersion containing 10 mass% of colloidal silica particles and having a pH of 8.0.
The zeta potential of the colloidal silica particles contained in the aqueous dispersion was -40 mV.

4.2.3. Preparation of aqueous dispersion containing organic-inorganic composite particles

50 parts by mass of the aqueous dispersion prepared in "4.2.2. Preparation of aqueous dispersion containing inorganic particles (colloidal silica particles)" was slowly added to 100 parts by mass of the aqueous dispersion prepared in "4.2.1. Preparation of aqueous dispersion containing surface-treated organic particles" over two hours with stirring. The mixture was then stirred for two hours to obtain an aqueous dispersion containing particles in which the silica particles adhered to the polymethyl methacrylate particles.
After the addition of 2 parts by mass of vinyltriethoxysilane to the resulting aqueous dispersion, the mixture was stirred for one hour. Then, 1 part by mass of tetraethoxysilane was added to the mixture. After stirring the mixture at 60°C for three hours, the mixture was cooled to room temperature to prepare an aqueous dispersion containing 10 mass% of organic-inorganic composite particles having an average particle diameter of 180 nm.
The organic-inorganic composite particles contained in the aqueous dispersion were observed using a scanning electron microscope. It was found that the silica particles adhered to 80% of the surface of each polymethyl methacrylate particle.

4.3. Example 1

4.3.1. Preparation of first chemical mechanical polishing aqueous dispersion

2 kg of fumed silica particles ("Aerosil #90" manufactured by Nippon Aerosil Co., Ltd., primary particle diameter: 20 nm, secondary particle diameter: 220 nm) were dispersed in 6.7 kg of ion-exchanged water using an ultrasonic mixer to obtain an aqueous dispersion. The mixture was filtered through a filter having a pore diameter of 5 micrometers to obtain an aqueous dispersion containing the fumed silica particles.
A polyethylene container was charged with the resulting aqueous dispersion containing the fumed silica particles in such an amount that the amount of silica was 1.2 mass%. After the addition of 0.5 mass% of quinaldic acid, 0.05 mass% of an acetylene diol-type nonionic surfactant ("Surfynol 465" manufactured by Air Products Japan, Inc., m+n=10 in the general formula (1)), and 1.0 mass% of ammonium persulfate, the mixture was diluted with ion-exchanged water. The mixture was then sufficiently stirred. After adjusting the pH of the mixture to 9.5 using a potassium hydroxide aqueous solution, the mixture was filtered through a filter having a pore diameter of 5 micrometers to obtain a first chemical mechanical polishing aqueous dispersion.

4.3.2. Preparation of second chemical mechanical polishing aqueous dispersion (chemical mechanical polishing aqueous dispersion according to the invention)

A polyethylene bottle was charged with the aqueous dispersion containing the colloidal silica 1 prepared in "4.1.3-2. Preparation of aqueous dispersion containing colloidal silica 2, 3, or 4" in such an amount that the amount of silica was 2 mass%. After the addition of 0.5 mass% of quinaldic acid, 0.3 mass% of maleic acid, 0.1 mass% of an acetylene diol-type nonionic surfactant ("Surfynol 485" manufactured by Air Products Japan, Inc., m+n=30 in the general formula (1)), and a 35 mass% hydrogen peroxide aqueous solution in such an amount that the amount of hydrogen peroxide was 0.3 mass%, the mixture was stirred for 15 minutes. The pH of the mixture was adjusted to 10.5 using potassium hydroxide. After the addition of ion-exchanged water so that the total amount of the components was 100 mass%, the mixture was filtered through a filter having a pore diameter of 5 micrometers to obtain a second chemical mechanical polishing aqueous dispersion S1 having a pH of 10.5.

4.3.3. Evaluation of polishing performance of first and second chemical mechanical polishing aqueous dispersions

4.3.3-1. Measurement of polishing rate of first chemical mechanical polishing aqueous dispersion

A polishing pad made of porous polyurethane ("IC1000" manufactured by Nitta Haas Inc.) was installed in a chemical mechanical polishing system ("EPO-112" manufactured by Ebara Corporation). Each polishing rate measurement substrate given below was chemically and mechanically polished for one minute under the following polishing

conditions while supplying the first chemical mechanical polishing aqueous dispersion. The polishing rate was calculated by the following method.

(i) Polishing rate measurement substrate

- A substrate in which a copper film with a thickness of 15,000 angstroms was provided on an 8-inch silicon substrate with a thermal oxide film - A substrate in which a tantalum film with a thickness of 2000 angstroms was provided on an 8-inch silicon substrate with a thermal oxide film
- A substrate in which a tantalum nitride film with a thickness of 2000 angstroms was provided on an 8-inch silicon substrate with a thermal oxide film

(ii) Polishing conditions

Head rotational speed: 70 rpm
Head load: 250 gf/cm$^2$
Table rotational speed: 70 rpm
First chemical mechanical polishing aqueous dispersion supply rate: 200 ml/min

(iii) Calculation of polishing rate

The thicknesses of the copper film, the tantalum film, and the tantalum nitride film were measured after polishing using a resistivity mapping system ("OmniMap RS75" manufactured by KLA-Tencor Corporation), and the polishing rate was calculated from the thickness reduced by chemical mechanical polishing and the polishing time.

(iv) Polishing rate calculation results

Polishing rate of copper film ($R_{Cu}$): 5200 angstroms/min
Polishing rate of barrier metal film (tantalum film) ($R_{BM}$): 30 angstroms/min
Polishing rate of barrier metal film (tantalum nitride film) ($R_{BM}$): 40 angstroms/min
Polishing rate of copper film/polishing rate of barrier metal film (tantalum film) ($R_{Cu}/R_{BM}$): 173
Polishing rate of copper film/polishing rate of barrier metal film (tantalum nitride film) ($R_{Cu}/R_{BM}$): 130

4.3.3-2. Measurement of polishing rate of second chemical mechanical polishing aqueous dispersion

A polishing pad made of porous polyurethane ("IC1000" manufactured by Nitta Haas Inc.) was installed in a chemical mechanical polishing system ("EPO-112" manufactured by Ebara Corporation). Each polishing rate measurement substrate given below was chemically and mechanically polished for one minute under the following polishing conditions while supplying the second chemical mechanical polishing aqueous dispersion. The polishing rate was calculated by the following method.

(i) Polishing rate measurement substrate

- A substrate in which a copper film with a thickness of 15,000 angstroms was provided on an 8-inch silicon substrate with a thermal oxide film
- A substrate in which a tantalum film with a thickness of 2000 angstroms was provided on an 8-inch silicon substrate with a thermal oxide film.
- A substrate in which a tantalum nitride film with a thickness of 2000 angstroms was provided on an 8-inch silicon substrate with a thermal oxide film
- A substrate in which a low-dielectric-constant insulating film ("Black Diamond" manufactured by Applied Materials) with a thickness of 10,000 angstroms was provided on an 8-inch silicon substrate

- A substrate in which a PETEOS film with a thickness of 10,000 angstroms was provided on an 8-inch silicon substrate

(ii) Polishing conditions

Head rotational speed: 70 rpm
Head load: 250 gf/$cm^2$
Table rotational speed: 70 rpm
Second chemical mechanical polishing aqueous dispersion supply rate: 200 ml/min

(iii) Calculation of polishing rate

The thicknesses of the copper film, the tantalum film, and the tantalum nitride film were measured after polishing using a resistivity mapping system ("OmniMap RS75" manufactured by KLA-Tencor Corporation), and the polishing rate was calculated from the thickness reduced by chemical mechanical polishing and the polishing time.
The thicknesses of the PETEOS film and the low-dielectric-constant insulating film were measured after polishing using an optical interference type thickness measurement device ("NanoSpec 6100" manufactured by Nanometrics Japan Ltd.). The polishing rate was calculated from the reduction in thickness due to chemical mechanical polishing and the polishing time.

(iv) Polishing rate

The polishing rate calculation results are shown in Table 2. In Table 2, the polishing rate of each layer is abbreviated as follows.

Polishing rate of copper film: $R_{Cu}$
Polishing rate of barrier metal film (tantalum film): $R_{BM}$ (tantalum film)
Polishing rate of barrier metal film (tantalum nitride film): $R_{BM}$ (tantalum nitride film)
Polishing rate of second insulating film (PETEOS film): $R_{In-2}$
Polishing rate of first insulating film (low-dielectric-constant insulating film) ("Black Diamond"): $R_{In-1}$

(v) Polishing rate calculation results

The results are shown in Table 2.

4.3.3-3. Production of polishing target substrates (1) and (2)

A silicon nitride film (thickness: 1000 angstroms) was deposited on a silicon substrate. After depositing a first insulating film (Black Diamond film) (thickness: 4500 angstroms) and a second insulating film (PETEOS film) (thickness: 500 angstroms), a pattern with a depression having a depth of 5000 angstroms and a width of 100 micrometers was formed. A barrier metal film (tantalum film) (thickness: 250 angstroms), a copper seed film (copper seed film, thickness: 1000 angstroms), and a copper plating film (thickness: 10,000 angstroms) were then deposited over the depression in this order. A patterned substrate (polishing target substrate (1)) in which the first insulating film (Black Diamond film), the second insulating film (PETEOS film), the barrier metal film (tantalum film), and the copper film were stacked in this order and the depression was filled with the copper film, was thus produced.
A patterned substrate (polishing target substrate (2)) in which a first insulating film (Black Diamond film), a second insulating film (PETEOS film), a barrier metal film (tantalum nitride film), and a copper film were stacked in this order and a depression was filled with copper was produced in the same manner as the polishing target substrate (1), except for forming a tantalum nitride film instead of the tantalum film.

4.3.3-4. Chemical mechanical polishing of polishing target substrate

A polishing pad made of porous polyurethane ("IC1000" manufactured by Nitta Haas Inc.) was installed in a chemical mechanical polishing system ("EPO-112" manufactured by Ebara Corporation). The polishing target substrates (1) and (2) were subjected to a two-stage chemical mechanical polishing process under the following polishing conditions.

(i) First polishing step

The polishing target substrate (1) or (2) was installed in a chemical mechanical polishing system ("EPO-112" manufactured by Ebara Corporation). The polishing target surface was polished for 2.75 minutes under the following polishing conditions while supplying the first polishing aqueous dispersion using a polishing pad made of porous polyurethane ("IC1000" manufactured by Nitta Haas Inc.).

After the first polishing step, the depth of dishing which had occurred in the copper interconnect area (width: 100 micrometers) of the polishing target surface was measured using a surface roughness meter ("P-10" manufactured by KLA-Tencor Corporation). The depth of dishing was found to be 500 angstroms. The term "depth of dishing" used herein refers to the distance (difference in height) between the plane formed by the insulating layer or the barrier metal layer on the surface of the substrate and the lowest portion of the copper interconnect area. The copper interconnect area was observed for 200 unit areas (120×120 micrometers) at random by darkfield illumination using an optical microscope to measure the number of unit areas in which scratches had occurred (i.e., the number of scratches). The number of scratches was found to be zero. The polishing conditions were as follows.

Head rotational speed: 70 rpm
Head load: 250 gf/$cm^2$
Table rotational speed: 70 rpm
Chemical mechanical polishing aqueous dispersion supply rate: 200 ml/min

The polishing time (2.75 minutes) in the first polishing step was calculated by the following equation.

$$\text{Polishing time (min)} = T_1/R_{Cu} \times 1.3$$

where, $T_1$ indicates the thickness of the copper film, and $R_{Cu}$ indicates the polishing rate of the copper film. In this example, $T_1$=11,000 angstroms, and $R_{Cu}$=5200 angstroms/min.

(ii) Second polishing step

After the first polishing step, a polishing process was performed using a polishing time (shown in Table 2) calculated by the following equation while supplying the second polishing aqueous dispersion S1 instead of the first polishing aqueous dispersion.

$$\text{Polishing time (min)} = T_2/R_{BM} + T_3/R_{In-2}$$

where, $T_2$ indicates the thickness of the barrier metal film, $R_{BM}$ indicates the polishing rate of the barrier metal film, $T_3$ indicates the thickness of the second insulating film, $R_{In-2}$ indicates the polishing rate of the second insulating film. In this example, $T_2$=250 angstroms and $T_3$=500 angstroms.

After the second polishing step, the depth of dishing which had occurred in the copper interconnect area (width: 100 micrometers) of the polishing target surface of the polishing target substrate (1) or (2)was measured using a surface roughness meter ("P-10" manufactured by KLA-Tencor Corporation).

The copper interconnect area was observed for 200 unit areas (120×120 micrometers) at random by darkfield illumination using an optical microscope to measure the number of unit areas in which scratches had occurred (i.e., the number of scratches).

The results are shown in Table 2.

4.4. Examples 2 to 9 and Comparative Examples 1 and 2

Second chemical mechanical polishing aqueous dispersions S2 to S9 and R1 to R3 were prepared in the same manner as in Example 1, except for changing the type and the amount of each component of the second chemical

mechanical polishing aqueous dispersion as shown in Table 1.

In Examples 2 to 9 and Comparative Examples 1 and 2, the polishing performance was evaluated in the same manner as in Example 1 using the second chemical mechanical polishing aqueous dispersions S2 to S9 and R1 to R3. In Examples 2, 5, 6, and 9, an acetylene diol-type nonionic surfactant ("Surfynol 465" manufactured by Air Products Japan, Inc., m+n=10 in the general formula (1)) was used as the component (E). The results are shown in Table 2.

TABLE 2

| | | | Example 1 | Example 2 | Example 3 | Example 4 | Example 5 | Example 6 | Example 7 | Example 8 | Example 9 | Comparative Example 1 | Comparative Example 2 |
|---|---|---|---|---|---|---|---|---|---|---|---|---|---|
| Composition of aqueous dispersion | Aqueous dispersion | | S1 | S2 | S3 | S4 | S5 | S6 | S7 | S8 | S9 | R1 | R2 |
| | Abrasive grains: Colloidal silica | Type | 1 | 2 | 1 | 1 | 3 | 3 | 4 | 1 | 3 | - | - |
| | | Amount (mass%) | 6 | 3.5 | 8 | 5 | 4 | 3 | 5 | 2 | 2 | - | - |
| | Abrasive grains: Fumed silica | Type | - | - | - | - | - | - | - | Fumed silica 1 | Fumed silica 2 | Fumed silica 2 | Fumed silica 2 |
| | | Amount (mass%) | - | - | - | - | - | - | - | 1 | 1.5 | 2 | 1.5 |
| | Abrasive grains: Composite particles | Amount (mass%) | - | - | - | - | - | - | - | 3 | - | - | - |
| | Component (B) | Type | Quinaldic acid | Quinolinic acid | Quinaldic acid | Quinaldic acid | Quinaldic acid | Quinaldic acid | Quinolinic acid | Quinolinic acid | Quinaldic acid | - | Quinolinic acid |
| | | Amount (mass%) | 0.5 | 0.1 | 0.3 | 0.2 | 0.3 | 0.1 | 0.05 | 0.4 | 0.2 | - | 0.3 |
| | Component (C) | Type | Maleic acid | Maleic acid | Citric acid | Maleic acid | Malic acid | Maleic acid | Maleic acid | Maleic acid | Maleic acid | Oxalic acid | Propionic acid |
| | | Amount (mass%) | 0.3 | 0.9 | 0.3 | 0.6 | 0.3 | 1.0 | 0.6 | 0.4 | 0.6 | 0.5 | 0.1 |
| | Component (D) | Type | Hydrogen peroxide | Hydrogen peroxide | Hydrogen peroxide | Hydrogen peroxide | Hydrogen peroxide | Hydrogen peroxide | Hydrogen peroxide | Hydrogen peroxide | Hydrogen peroxide | Hydrogen peroxide | Ammonium persulfate |
| | | Amount (mass%) | 0.3 | 0.1 | 0.5 | 0.3 | 0.5 | 0.3 | 0.1 | 1.0 | 1.5 | 3.0 | 1.0 |
| | Component (E) | Type | Surfynol 485 | Surfynol 465 | Surfynol 485 | Surfynol 485 | Surfynol 465 | Surfynol 465 | Surfynol 485 | Surfynol 485 | Surfynol 465 | Ammonium lauryl sulfate | - |
| | | Amount (mass%) | 0.1 | 0.05 | 0.01 | 0.3 | 0.01 | 0.005 | 0.05 | 0.005 | 0.1 | 0.005 | - |
| | WB/WC | | 1.67 | 0.11 | 1.00 | 0.33 | 1.00 | 0.10 | 0.08 | 1.00 | 0.33 | 0 | 3.00 |
| | pH | | 10.5 | 10.5 | 11.5 | 10.0 | 10.0 | 9.5 | 10.0 | 10.5 | 10.5 | 10.0 | 8.5 |
| Polishing characteristics | $R_{Cu}$ (angstroms/min) | | 430 | 200 | 450 | 400 | 420 | 370 | 550 | 340 | 280 | 1850 | 5800 |
| | $R_{BM}$ (tantalum) (angstroms/min) | | 580 | 580 | 790 | 670 | 550 | 680 | 1320 | 690 | 600 | 210 | 90 |
| | $R_{BM}$ (tantalum nitride) (angstroms/min) | | 900 | 950 | 1340 | 1050 | 820 | 990 | 1480 | 1150 | 940 | 250 | 130 |
| | $R_{In-2}$ (PETEOS) (angstroms/min) | | 420 | 350 | 530 | 340 | 350 | 320 | 630 | 320 | 400 | 450 | 200 |
| | $R_{In-1}$ (BD) (angstroms/min) | | 130 | 130 | 250 | 50 | 200 | 430 | 310 | 400 | 90 | 950 | 310 |
| | $R_{BM}$ (tantalum) / $R_{Cu}$ | | 1.35 | 2.90 | 1.76 | 1.68 | 1.31 | 1.70 | 2.40 | 2.03 | 2.14 | 0.11 | 0.02 |
| | $R_{BM}$ (tantalum nitride) / $R_{Cu}$ | | 2.09 | 4.75 | 2.98 | 2.63 | 1.95 | 2.68 | 2.69 | 3.38 | 3.36 | 0.14 | 0.02 |
| | $R_{In-2}$ (PETEOS) / $R_{Cu}$ | | 0.98 | 1.75 | 1.18 | 0.85 | 0.83 | 0.86 | 1.15 | 0.94 | 1.43 | 0.24 | 0.03 |
| | $R_{In-1}$ (BD) / $R_{Cu}$ | | 0.30 | 0.65 | 0.56 | 0.13 | 0.48 | 1.16 | 0.56 | 1.18 | 0.32 | 0.51 | 0.05 |
| | $R_{In-2}$ (PETEOS) / $R_{In-1}$ (BD) | | 3.23 | 2.69 | 2.12 | 6.80 | 1.75 | 0.74 | 2.03 | 0.08 | 4.44 | 0.47 | 0.65 |
| Evaluation of two-stage polishing | Barrier metal = tantalum | | | | | | | | | | | | |
| | | Polishing time of second polishing step (min) | 1.62 | 1.86 | 1.26 | 1.84 | 1.88 | 1.96 | 0.98 | 1.92 | 1.67 | 2.30 | 5.28 |
| | | Interconnect (100 micrometers) dishing (angstroms) | 210 | 240 | 280 | 280 | 490 | 240 | 150 | 230 | 170 | 750 | 850 |
| | | Copper interconnect scratches ( number) | 0 | 1 | 0 | 0 | 0 | 2 | 0 | 0 | 2 | 10 | 8 |
| | Barrier metal = tantalum nitride | | | | | | | | | | | | |
| | | Polishing time of second polishing step (min) | 1.47 | 1.69 | 1.13 | 1.71 | 1.73 | 1.82 | 0.96 | 1.78 | 1.52 | 2.11 | 4.42 |
| | | Interconnect (100 micrometers) dishing (angstroms) | 180 | 220 | 250 | 220 | 470 | 200 | 130 | 210 | 160 | 790 | 840 |
| | | Copper interconnect scratches ( number) | 0 | 1 | 0 | 0 | 0 | 1 | 0 | 0 | 3 | 15 | 10 |

As shown in Table 2, an appropriate polishing rate could be achieved when chemically and mechanically polishing the first and second insulating films by subjecting the polishing target substrate to chemical mechanical polishing using the chemical mechanical polishing aqueous dispersion of each of Examples 1 to 9. Moreover, occurrence of scratches and dishing in the polishing target surface could be prevented, and a polished surface having excellent flatness could be obtained efficiently.

On the other hand, when subjecting the polishing target substrate to chemical mechanical polishing using the chemical mechanical polishing aqueous dispersion of each of Comparative Examples 1 and 2, the polishing rate could not be increased. Moreover, scratches and dishing occurred on the polishing target surface.

4.5. Example 10

4.5.1. Preparation of second chemical mechanical polishing aqueous dispersion using kit for preparing chemical mechanical polishing aqueous dispersion

4.5.1-1. Preparation of liquid (I)

A polyethylene bottle was charged with the aqueous dispersion containing the colloidal silica 1 prepared in "4.1.3-2. Preparation of aqueous dispersion containing colloidal silica 2, 3, or 4" in such an amount that the amount of silica was 6.38 mass%. After the addition of 0.53 mass% of quinaldic acid, 0.32 mass% of maleic acid, 0.11 mass% of an acetylene diol-type nonionic surfactant ("Surfynol 485" manufactured by Air Products Japan, Inc., m+n=30 in the general formula (1)), the mixture was stirred for 15 minutes. The pH of the mixture was adjusted to 10.5 using potassium hydroxide. After the addition of ion-exchanged water so that the total amount of the components was 100 mass%, the mixture was filtered through a filter having a pore diameter of 5 micrometers to obtain a liquid (I) A1 (aqueous dispersion).

4.5.1-2. Preparation of liquid (II)

Hydrogen peroxide was dissolved in ion-exchanged water so that the hydrogen peroxide concentration was 5

wt% to obtain a liquid (II) B1. A kit for preparing a chemical mechanical polishing aqueous dispersion including the liquid (I) A1 and the liquid (II) B1 was prepared by the above steps.

4.5.2. Preparation of second chemical mechanical polishing aqueous dispersion using kit for preparing chemical mechanical polishing aqueous dispersion

100 parts by mass of the liquid (I) A1 and 6.38 parts by mass of the liquid (II) B1 prepared as described above were mixed to prepare a chemical mechanical polishing aqueous dispersion S10. The pH of the chemical mechanical polishing aqueous dispersion S10 was 10.5. Since the chemical mechanical polishing aqueous dispersion S10 had the same composition and pH as those of the chemical mechanical polishing aqueous dispersion S1 prepared in Example 1, the chemical mechanical polishing aqueous dispersion S10 can be considered to be the same as the chemical mechanical polishing aqueous dispersion S1 prepared in Example 1.
The polishing performance was evaluated in the same manner as in Example 1, except for using the chemical mechanical polishing aqueous dispersion S10 prepared as described above as the second chemical mechanical polishing aqueous dispersion instead of the chemical mechanical polishing aqueous dispersion S 1. The results were the same as those of Example 1.

4.6. Example 11

4.6.1. Preparation of second chemical mechanical polishing aqueous dispersion using kit for preparing chemical mechanical polishing aqueous dispersion

4.6.1-1. Preparation of liquid (I)

A polyethylene bottle was charged with the aqueous dispersion containing the colloidal silica 1 prepared in "4.1.3-2. Preparation of aqueous dispersion containing colloidal silica 2, 3, or 4" in such an amount that the amount of silica was 12.0 mass%. After the addition of potassium hydroxide and a 35 mass% hydrogen peroxide aqueous solution in such an amount that the amount of hydrogen peroxide was 0.6 mass%, the mixture was stirred for 15 minutes. After the addition of ion-exchanged water so that the total amount of the components was 100 wt%, the mixture was filtered through a filter having a pore diameter of 5 micrometers to obtain a liquid (I) A2 (aqueous dispersion).

4.6.1-2. Preparation of liquid (II)

A polyethylene bottle was charged with 1.0 mass% of quinaldic acid, 0.6 mass% of maleic acid, and 0.2 mass% of an acetylene diol-type nonionic surfactant ("Surfynol 485" manufactured by Air Products Japan, Inc., m+n=30 in the general formula (1)). The mixture was then stirred for 15 minutes. After the addition of ion-exchanged water so that the total amount of the components was 100 wt%, the mixture was filtered through a filter having a pore diameter of 5 micrometers to obtain a liquid (II) A3 (aqueous dispersion). A kit for preparing a chemical mechanical polishing aqueous dispersion including the liquid (I) A2 and the liquid (II) A3 was prepared by the above steps.

4.6.2. Evaluation of polishing performance of second polishing aqueous dispersion

50 parts by mass of the liquid (I) A2 and 50 parts by mass of the liquid (II) A3 prepared as described above were mixed to prepare a chemical mechanical polishing aqueous dispersion S 11. The pH of the chemical mechanical polishing aqueous dispersion S11 was 10.5. Since the chemical mechanical polishing aqueous dispersion S11 had the same composition and pH as those of the chemical mechanical polishing aqueous dispersion S1 prepared in Example 1, the chemical mechanical polishing aqueous dispersion S11 can be considered to be the same as the chemical mechanical polishing aqueous dispersion S1 prepared in Example 1.
The polishing performance was evaluated in the same manner as in Example 1, except for using the chemical mechanical polishing aqueous dispersion S11 prepared as described above as the second chemical mechanical polishing aqueous dispersion instead of the chemical mechanical polishing aqueous dispersion S 1. The results were the same as those of Example 1.

4.7. Example 12

4.7.1. Preparation of second chemical mechanical polishing aqueous dispersion using kit for preparing chemical mechanical polishing aqueous dispersion

4.7.1-1. Preparation of liquid (I)

A polyethylene bottle was charged with the aqueous dispersion containing the colloidal silica 1 prepared in "4.1.3-2. Preparation of aqueous dispersion containing colloidal silica 2, 3, or 4" in such an amount that the amount of silica was 12.77 mass%. After the addition of potassium hydroxide, the mixture was stirred for 15 minutes. After the addition of ion-exchanged water so that the total amount of the components was 100 wt%, the mixture was filtered through a filter having a pore diameter of 5 micrometers to obtain a liquid (I) A4 (aqueous dispersion).

4.7.1-2. Preparation of liquid (II)

A polyethylene bottle was charged with 1.06 mass% of quinaldic acid, 0.64 mass% of maleic acid, and 0.21 mass% of an acetylene diol-type nonionic surfactant ("Surfynol 485" manufactured by Air Products Japan, Inc., m+n=30 in the general formula (1)). The mixture was then stirred for 15 minutes. After the addition of ion-exchanged water so that the total amount of the components was 100 wt%, the mixture was filtered through a filter having a pore diameter of 5 micrometers to obtain a liquid (II) A5 (aqueous dispersion). A kit for preparing a chemical mechanical polishing aqueous dispersion including the liquid (I) A4, the liquid (II) A5, and the liquid (III) B1 (i.e., the liquid (II) B1 obtained in Example 10) was prepared by the above steps.

4.7.2. Evaluation of polishing performance of second polishing aqueous dispersion

50 parts by mass of the liquid (I) A4, 50 parts by mass of the liquid (II) A5, 6.38 parts by mass of the liquid (III) B1 prepared as described above were mixed to prepare a chemical mechanical polishing aqueous dispersion S12. The pH of the chemical mechanical polishing aqueous dispersion S12 was 10.5. Since the chemical mechanical polishing aqueous dispersion S12 had the same composition and pH as those of the chemical mechanical polishing aqueous dispersion S1 prepared in Example 1, the chemical mechanical polishing aqueous dispersion S12 can be considered to be the same as the chemical mechanical polishing aqueous dispersion S1 prepared in Example 1.

The polishing performance was evaluated in the same manner as in Example 1, except for using the chemical mechanical polishing aqueous dispersion S12 prepared as described above as the second chemical mechanical polishing aqueous dispersion instead of the chemical mechanical polishing aqueous dispersion S 1. The results were the same as those of Example 1.

## Claims

**1.** A chemical mechanical polishing aqueous dispersion comprising:

(A) abrasive grains;
(B) at least one of quinolinecarboxylic acid and pyridinecarboxylic acid;
(C) an organic acid other than quinolinecarboxylic acid and pyridinecarboxylic acid;
(D) an oxidizing agent; and (E) a nonionic surfactant having a triple bond,
the mass ratio (WB/WC) of the amount (WB) of the component (B) to the amount (WC) of the component (C) being 0.01 or more and less than 2; and
the component (E) being shown by the following general formula (1),

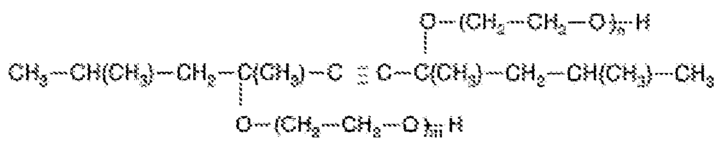

(1)

wherein m and n individually represent integers equal to or larger than one, provided that m+n≤50 is satisfied.

**2.** A chemical mechanical polishing method that chemically and mechanically polishes a polishing target, the polishing target comprising an insulating film that is provided above a substrate and has a depression, and a copper film provided on the insulating film through a barrier metal film, the insulating film comprising a first insulating film and a second insulating film that is provided on the first insulating film and has a dielectric constant higher than that of the first insulating film, the method comprising:

a first polishing step of chemically and mechanically polishing the copper film using a first chemical mechanical polishing aqueous dispersion utilizing the barrier metal film as an index; and
a second polishing step of chemically and mechanically polishing the second insulating film using a second chemical mechanical polishing aqueous dispersion utilizing the first insulating film as an index,
the first chemical mechanical polishing aqueous dispersion comprising abrasive grains, an organic acid, an oxidizing agent, and at least one of ammonia and an ammonium ion;
the second chemical mechanical polishing aqueous dispersion comprising (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, the mass ratio (WB/WC) of the amount (WB) of the component (B) to the amount (WC) of the component (C) being 0.01 or more and less than 2, and the component (E) being shown by the following general formula (1),

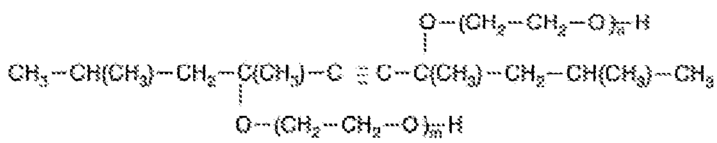

(1)

wherein m and n individually represent integers equal to or larger than one, provided that m+n≤50 is satisfied;
when chemically and mechanically polishing the copper film and the barrier metal film using the first chemical mechanical polishing aqueous dispersion under identical conditions, a polishing rate ratio ($R_{Cu}/R_{BM}$) of a polishing rate ($R_{Cu}$) of the copper film to a polishing rate ($R_{BM}$) of the barrier metal film being 50 or more; and
when chemically and mechanically polishing the copper film, the barrier metal film, the first insulating film, and the second insulating film using the second chemical mechanical polishing aqueous dispersion under identical conditions, a polishing rate ratio ($R_{BM}/R_{Cu}$) of a polishing rate ($R_{BM}$) of the barrier metal film to a polishing rate ($R_{Cu}$) of the copper film being 1.2 or more, a polishing rate ratio ($R_{In-2}/R_{Cu}$) of a polishing rate ($R_{In-2}$) of the second insulating film to the polishing rate ($R_{Cu}$) of the copper film being 0.5 to 2, and a polishing rate ratio ($R_{In-2}/R_{In-1}$) of the polishing rate ($R_{In-2}$) of the second insulating film to a polishing rate ($R_{In-1}$) of the first insulating film being 0.5 to 10.

**3.** A chemical mechanical polishing kit comprising a first chemical mechanical polishing aqueous dispersion and a second chemical mechanical polishing aqueous dispersion,
the first chemical mechanical polishing aqueous dispersion and the second chemical mechanical polishing aqueous dispersion being provided in a non-mixed state; and
the first chemical mechanical polishing aqueous dispersion comprising abrasive grains, an organic acid, an oxidizing agent, and an ammonia component that comprises at least one of ammonia and an ammonium ion; and the second chemical mechanical polishing aqueous dispersion comprising (A) abrasive grains, (B) at least one of quinolinecarboxylic acid and pyridinecarboxylic acid, (C) an organic acid other than quinolinecarboxylic acid and pyridinecarboxylic acid, (D) an oxidizing agent, and (E) a nonionic surfactant having a triple bond, the mass ratio (WB/WC) of the amount (WB) of the component (B) to the amount (WC) of the component (C) being 0.01 or more and less than 2, and the component (E) being shown by the following general formula (1),

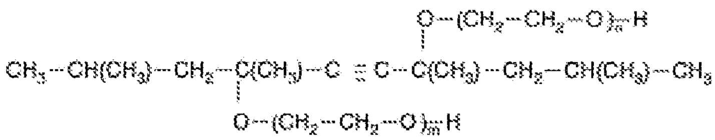

(1)

wherein m and n individually represent integers equal to or larger than one, provided that m+n≤50 is satisfied.

**4.** A kit for preparing the chemical mechanical polishing aqueous dispersion according to claim 1 by mixing a liquid (I) and a liquid (II),
the liquid (I) being an aqueous dispersion comprising the component (A), the component (B), the component (C), and the component (E); and
the liquid (II) comprising the component (D).

**5.** A kit for preparing the second chemical mechanical polishing aqueous dispersion according to claim 3 by mixing a liquid (I) and a liquid (II),
the liquid (I) being an aqueous dispersion comprising the component (A), the component (B), the component (C), and the component (E); and
the liquid (II) comprising the component (D).

**6.** A kit for preparing the chemical mechanical polishing aqueous dispersion according to claim 1 by mixing a liquid (I) and a liquid (II),
the liquid (I) being an aqueous dispersion comprising the component (A); and
the liquid (II) comprising the component (B) and the component (C).

**7.** A kit for preparing the second chemical mechanical polishing aqueous dispersion according to claim 3 by mixing a liquid (I) and a liquid (II),
the liquid (I) being an aqueous dispersion comprising the component (A); and
the liquid (II) comprising the component (B) and the component (C).

**8.** A kit for preparing the chemical mechanical polishing aqueous dispersion according to claim 1 by mixing a liquid (I), a liquid (II), and a liquid (III),
the liquid (I) being an aqueous dispersion comprising the component (A);
the liquid (II) comprising the component (B) and the component (C); and
the liquid (III) comprising the component (D).

**9.** A kit for preparing the second chemical mechanical polishing aqueous dispersion according to claim 3 by mixing a liquid (I), a liquid (II), and a liquid (III),
the liquid (I) being an aqueous dispersion comprising the component (A);
the liquid (II) comprising the component (B) and the component (C); and
the liquid (III) comprising the component (D).

**10.** The kit according to claim 6,
wherein the liquid (I) further comprises one or more components selected from the component (B), the component (C), the component (D), and the component (E).

**11.** The kit according to claim 7,
wherein the liquid (I) further comprises one or more components selected from the component (B), the component (C), the component (D), and the component (E).

**12.** The kit according to claim 8,
wherein the liquid (I) further comprises one or more components selected from the component (B), the component (C), the component (D), and the component (E).

**13.** The kit according to claim 9,

wherein the liquid (I) further comprises one or more components selected from the component (B), the component (C), the component (D), and the component (E).

**14.** The kit according to claim 6,
wherein the liquid (II) further comprises one or more components selected from the component (A), the component (D), and the component (E).

**15.** The kit according to claim 7,
wherein the liquid (II) further comprises one or more components selected from the component (A), the component (D), and the component (E).

**16.** The kit according to claim 8,
wherein the liquid (II) further comprises one or more components selected from the component (A), the component (D), and the component (E).

**17.** The kit according to claim 9,
wherein the liquid (II) further comprises one or more components selected from the component (A), the component (D), and the component (E).

FIG.1A

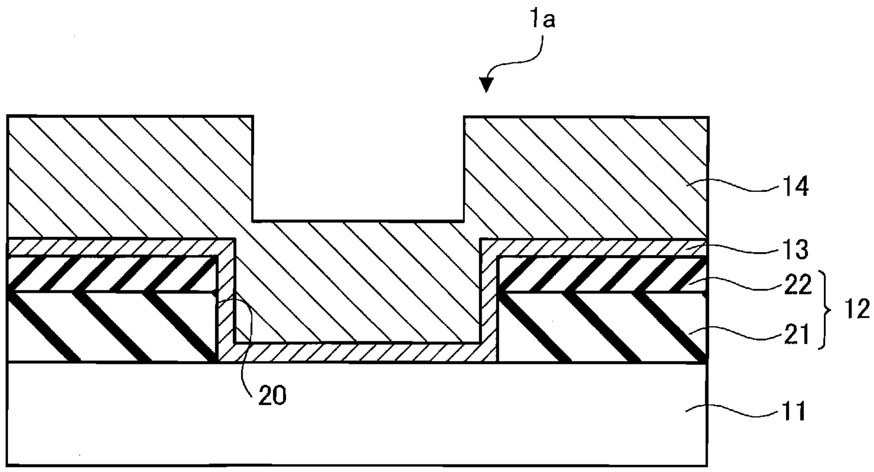


FIG.1B

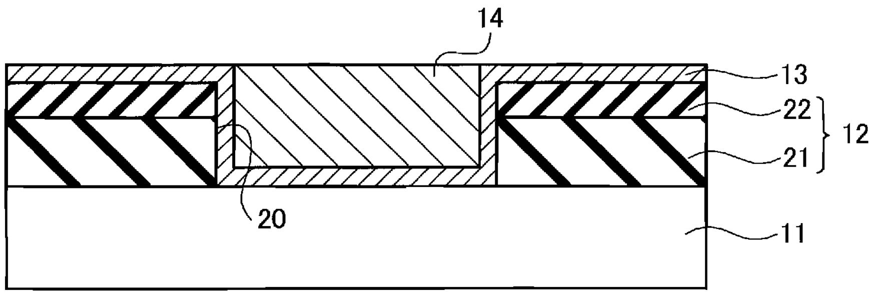


FIG.1C

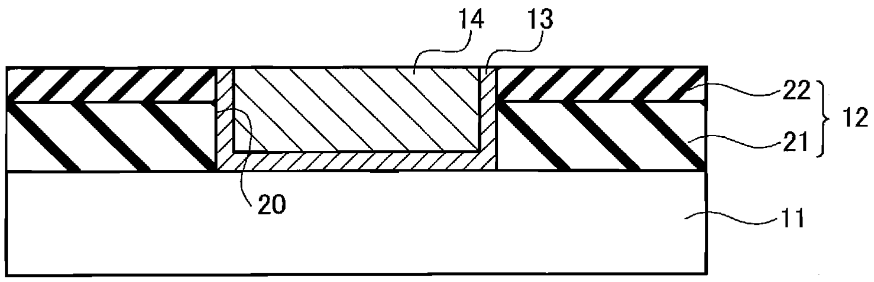


FIG.1D

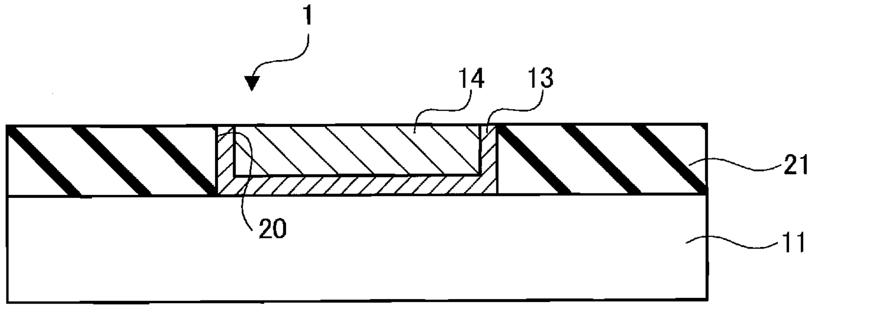

FIG.2A

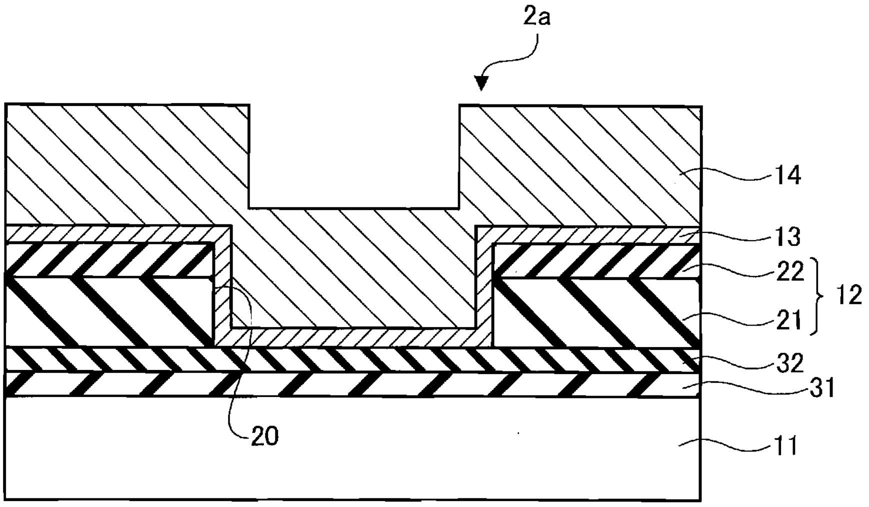


FIG.2B

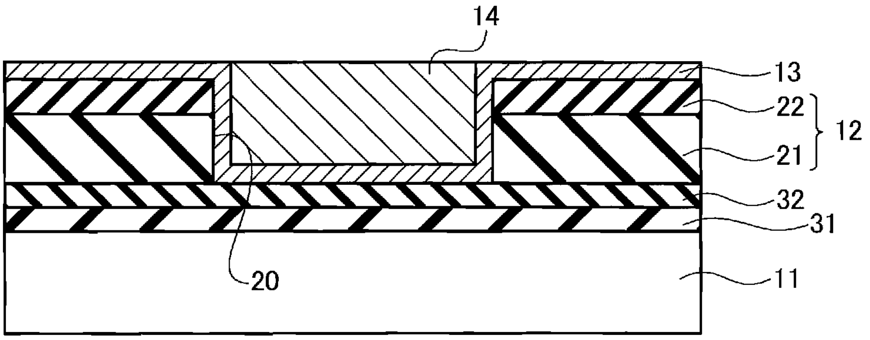


FIG.2C

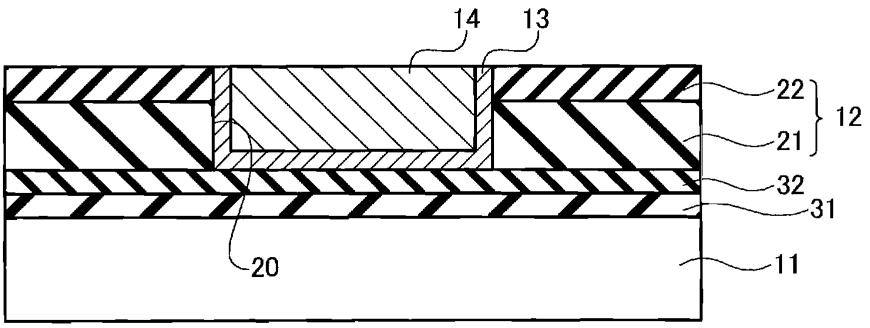


FIG.2D

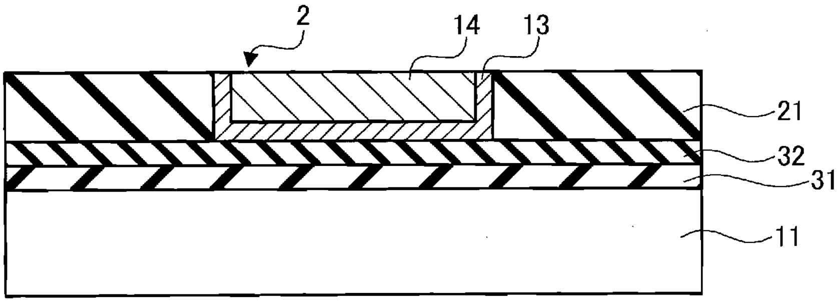

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001196336 A